# EUROPEAN PATENT APPLICATION

(11) **EP 1 510 861 A1**
(43) Date of publication of application: **02.03.2005**
(21) Application number: 03019266.0
(22) Date of filing: 26.08.2003
(51) Int. Cl.: G03F 7/00, H01L 21/033

(54) **Method for patterning organic materials or combinations of organic and inorganic materials**

(71) Applicant: Sony International (Europe) GmbH, 10785 Berlin (DE)
(72) Inventor: Harnack, Oliver, 70327 Stuttgart (DE); Bernard, Isabelle, 70327 Stuttgart (DE); Yasuda, Akio, 70327 Stuttgart (DE); Vossmeyer, Tobias, 70327 Stuttgart (DE)
(74) Representative: Appelt, Christian W.

(57) **Abstract**

The present application refers to a method of patterning organic materials or organic/inorganic materials onto a substrate, comprising the following steps:
(1) patterning of a water-soluble material "A" onto a surface of the substrate, thereby forming a substrate/material "A" surface;
(2) depositing organic or organic/inorganic material "B" onto the substrate/material "A" surface;
(3) lifting-off material "A" in aqueous solution;
wherein, step (1) comprises the following steps:
(1a) patterning of a photoresist material onto the substrate surface, thereby forming a substrate/photoresist material surface;
(1b) depositing the water soluble material "A" onto the substrate/photoresist material surface;
(1c) lifting-off the photoresist material in an organic solvent;
or, alternatively, step (1) comprises the following steps:
(1a') depositing the water-soluble material "A" onto the substrate surface, thereby forming a substrate/material "A" surface;
(1b') patterning the photoresist material onto the substrate/material "A" surface;
(1c') etching the unmasked material "A" in aqueous solution;
(1d') lifting-off the photoresist material in an organic solvent.

The present application also refers to the use of said method, to a pattern of organic materials or organic/inorganic materials prepared by said method, and to a substrate carrying such patterns. The application also refers to the use of a patterned nanoparticle film.

## Description

The present application refers to a method of patterning organic materials or organic/inorganic materials onto a substrate, and also refers to the use of said method. The application further refers to a pattern of organic or organic/inorganic materials prepared by the method of the present application, and to a substrate carrying such patterns. The application also refers to the use of a patterned nanoparticle film.

### Background of the invention

A basic requirement for developing organic devices and devices based on organic/inorganic composite materials is the presence of a patterning technology which is solvent-compatible with organic materials. Various photoresist systems are widely used for patterning inorganic materials. However, for patterning of organic materials, photoresists have the disadvantage that they also rely on organic solvents. If the solvent of the photoresist system comes into contact with the organic material then mixing and lifting of the organic material and the photoresist might occur which removes the organic material or changes its properties.

Another approach could be the use of water-soluble materials. Roas (1991, Appl Phys Lett 59: 2594) described the application of a water-soluble CaO mask to pattern YBa₂Cu₃Oₓinsulator multilayers. First, a photoresist pattern was formed on top of a substrate. Then, CaO and zirconium (Zr) was deposited onto this structure, followed by a lift-off in acetone. Then, YBa₂Cu₃Oₓ, SrTiO₃ or LaAlO₃ was deposited onto the CaO/Zr structure at a temperature around 800°C. The high-temperature stability of CaO is the important advantage of this method used to pattern ceramic thin films. However, organic materials are not stable at such temperature and the possibility of using the water soluble CaO mask to pattern organic or organic/inorganic materials was not attempted or described.

The patterning of molybdenum (Mo) by local oxidation using a biased AFM tip under ambient humidity was described in Rolandi *et al*. (2002, Adv Mater 14: 191). Similar to CaO, the molybdenum oxide (MoO) could be dissolved by water. In addition to Mo, also Ge or Cr were mentioned as candidates for the mask material. This process was primarily used for defining inorganic, metallic structures with nanometer resolution. The major shortcoming of this technique is the low speed due to serial writing (non-parallel processing).

Recently, a nanoparticle layer patterning method was published that is based on using aluminium as mask material which is soluble under acidic or basic conditions (Hua *et al*. 2002, Nano Lett 2: 1219; Hua 2002, J Nanoscience Techno 3/4: 357). One of the described routes is to pattern polystyrene nanoparticles by oxygen plasma etching through an aluminium mask. In addition, it was shown that different kinds of nanoparticle layers can be patterned on the same wafer by employing the oxygen plasma etching method in combination with a lift-off step using a basic aluminium etching solution (e.g. photoresist developer). One of the disadvantages of this approach is that the etching solution for aluminium has to have either relatively high or low pH values. Such conditions are not compatible with many material systems. In addition, oxygen plasma etching of inorganic/organic composites may lead to residual inorganic material on the wafer surface. Further disadvantages are: (a) the whole substrate has first to be unselectively coated with the nanoparticle component; (b) harsh etching conditions have to be applied to remove the particles on non-covered parts; (c) this destructive technique may not be compatible with circuit elements on the chip as well as other materials, which are already deposited on the substrate. Another difference is, that their patterning method was employed for water-soluble nanoparticles, and not extended to particles which are deposited from organic solutions.

Other patterning techniques that were widely reported in conjunction with nanoparticle layers are microcontact printing (Xia and Whitesides 1998, Angew Chem 110: 568; Zeng *et al*., 2002, Adv Mater 14: 569) and dip-pen nanolithograpyh (Piner *et al*. 1999, Science 283:661; Hong *et al*. 1999, Science 286: 523; Porter *et al*. 2002, Nano Lett 2:1369; Demers *et al*. 2001, Angew Chem Int Ed 2001, 40: 3071). In the former case, a stamp is used to introduce molecular binding sites on a surface where nanoparticle layers can attach. The resolution is limited by the accuracy of the stamp. Also, this method suffers from non-specific binding of nanoparticles to areas where no binding molecule was introduced.

The dip-pen method employs a tip of, for example, silicon to "write" a thin line of a molecular layer onto a surface, or to destroy certain spots of a previously deposited layer of materials.

The main disadvantage of this method is the limited patterning speed since the process is serial.

A major problem of the state-of-the-art patterning methods is the high degree of non-specific binding. This accounts for those techniques that rely on self-assembly from organic solutions and, especially if the assembly step has to be repeated, to gain a sufficient film thickness. This is exemplified by the layer-by-layer deposition of the metal nanoparticle films, as described by Bethell *et al*. (1996, Eletroanal Chem 406: 137) and as is well known to persons skilled in the art.

Vossmeyer *et al*. (1998, J Appl Phys 84: 3664) demonstrated that nanoparticle layers can be efficiently patterned by modifying a self-assembled molecular layer with UV light. However, the major drawback of this process is the limited selectivity and the exposure step, which preferably requires a wet wafer surface.

As mentioned above, limited selectivity mostly occur when the nanoparticles are repeatedly deposited (layer-by-layer) onto a substrate surface. For (sub-)monolayer assembly, the photolithographic methods are actually quite selective (Vossmeyer *et al*. 1998, J Appl Phys 84: 3664; Fodor *et al*. 1991, Science 251: 767). The major drawback is, however, that the whole substrate has to be covered first with the photosensitive self-assembled monolayer (SAM).

Parker *et al*. (1999, App Phys Lett 74: 2833) used an organic resist to pattern organic nanoparticles but, as they confirmed, this "leaves a resist/cluster amalgam". In addition, the use of the resist was limited to drop-coating instead of dip-coating, and therefore is not suitable for the layer-by-layer technique.

A number of publications describe the patterning of nanoparticle structures by using biological templates (S-layers) (Mertig *et al*. 1999, Eur Phys J D9: 45) or biological linking molecules like DNA molecules (Taton *et al*. 2000, Chem Soc 122: 6305). Other reports describe how to bind nanoparticles to proteins to create nanostructures (Mann *et al*. 2000, Adv Mater 12: 147). These methods have in common that the created structures are not spatially defined but occupy the whole surface area which was treated.

Electron beam induced patterning of gold nanoclusters stabilised with organic ligands was published by Lin *et al*. (2001, Appl Phys Lett 78: 1915) and Bedson *et al*. (2001, Appl Phys Lett 78: 1921). In both cases, the immobilisation of the nanoparticles on the surface was caused by electron beam assisted stripping the organic ligand from the nanoparticles. The untreated nanoparticles could be washed away in organic solvents. It has to be noted that this method modifies (destroys) the organic matrix around the nanoparticles; therefore its application range is limited.

A recently published review article also mentioned methods like polymer-linking, electrostatic-linking, and covalent-linking to form architectures from nanoparticles, i.e. molecule composites (Shipway *et al*. 2000, ChemPhysChem 1: 18).

Another problem is that for some of the state-of-the art methods complicated chemical reactions have to be performed which require a number of different, partly hazardous chemicals. A simple method which relies on very few and preferably non-toxic chemicals would be beneficial.

Therefore, there is a need for providing a technique for patterning organic materials or combinations of organic and inorganic materials, in the following mostly referred to as "organic or organic/inorganic materials". In particular, there is a need for composites of organic or organic/inorganic materials like, for example, polymer or nanoparticle films which are deposited from organic solvents or organic molecule layers without bringing them into contact with the solvents of the photoresist system.

Advantageously, the method should be fully compatible with standard lithography (photo, electron beam, imprint lithography, and others). In addition, the method must be chemically and physically (e.g. with regard to temperature) compatible with the patterned film material. Furthermore, the method should suit for the integration of the film materials into complex circuitry and microchips.

It is an object of the present invention to provide for a method of patterning organic or organic/inorganic materials onto a substrate comprising the following steps:
(1) patterning of a water-soluble material "A" onto a surface of the substrate, thereby forming a substrate/material "A" surface;
(2) depositing organic or organic/inorganic material "B" onto the substrate/material "A" surface;
(3) lifting-off material "A" in aqueous solution.

In one embodiment, the patterning of water-soluble material "A" of step (1) above comprises the following steps:
(1a) patterning of a photoresist material onto the substrate surface, thereby forming a substrate/ photoresist material surface;
(1b) depositing the water soluble material "A" onto the substrate/photoresist material surface;
(1c) lifting-off the photoresist material in an organic solvent.

In another embodiment, the patterning of water-soluble material "A" of step (1) above comprises the following steps:
(1a') depositing the water-soluble material "A" onto the substrate surface, thereby forming a substrate/material "A" surface;
(1b') patterning the photoresist material onto the substrate/material "A" surface;
(1c') etching the unmasked material "A" in aqueous solution;
(1d') lifting-off the photoresist material in an organic solvent.

In one embodiment, the substrate surface is solid or soft.

In a preferred embodiment of the present invention, the substrate is a wafer.

In one embodiment, the water-soluble material "A" is selected from the group comprising inorganic materials, such as metal oxides and ceramics, and organic material, such as organic polymers and organic monomers, that can form thin layers.

In one embodiment, the water-soluble material "A" comprises Ca, CaO or Ca(OH)₂, and any combination thereof.

In one embodiment, a mercaptosilane layer is deposited onto the whole substrate including the water-soluble material "A" and also areas which are not covered by the water-soluble material "A".

In one embodiment, the organic or organic/inorganic material "B" is comprised of nanoparticles and an organic component.

In one embodiment, the nanoparticles are selected from the group comprising semiconductor nanoparticles, insulator nanoparticles, metallic nanoparticles, carbon black particles, and any combination thereof.

In one embodiment, the semiconductor or insulator nanoparticles are selected from the group comprising metal oxides, metal sufides, metal selenides, metal tellurides, metal phosphides, metal phosphates, II/VI semiconductors, and III/V semiconductors, and any combination thereof.

In one embodiment, the semiconductor nanoparticles are core-shell particles, preferably with a larger bandgap semiconductor material encapsulating a core of a semiconductor material with a smaller band gap.

In one embodiment, the metallic nanoparticles are selected from the group comprising Ag, Au, Pt, Pd, Pt/Co, and Co, and any combination thereof.

In a preferred embodiment, the organic component is comprised of organic linker molecules and/or organic ligand molecules.

In one embodiment, the organic linker molecules are attached to the substrate surface and to the nanoparticle surface, thereby linking the nanoparticles to the substrate surface.

In one embodiment, the organic linker molecules serve to interlink the nanoparticles.

In one embodiment, the type of linkage between the nanoparticles through the organic linker molecules is selected from the group comprising covalent linkages, complexation of metal ions, hydrogen bonds, ionic interactions, and any combination thereof.

In a preferred embodiment, the organic linker molecules are coupled to organic ligands, which are attached to the nanoparticles by suitable functional groups.

In one embodiment, the organic component is selected from the group comprising a polymer, a dendrimer, a DNA molecule, a RNA molecule, a protein molecule, a bi- or polyfunctional organic thiol, a bi- or polyfunctional organic disulfide, a bi- or polyfunctional organic amine, a bi- or polyfunctional carboxylic acid, a bi- or polyfunctional organic phosphine, a bi- or polyfunctional organic phosphineoxide and a bi- or polyfunctional organic isocyanide, or any combination thereof.

In a preferred embodiment, the organic or organic/inorganic material "B" is a nanoparticle/organic component composite film.

In one embodiment, the nanoparticle/organic component composite film is a carbon-black particles/polymer composite film.

In one embodiment, the depositing of the water-soluble material "A" is done by a technique selected from the group comprising thermal evaporation, electron-gun evaporation, plasma deposition, sputtering, and spin coating.

In one embodiment, the deposition of the organic or organic/inorganic material "B" is done by a technique selected from group of techniques comprising spin-coating, spray-coating, gas-phase deposition, thermal evaporation, dip-coating, drop-casting, solvent evaporation, air-brush deposition and jet-printing.

In one embodiment, the organic or organic/inorganic material "B" is dissolved in an organic solution prior to being deposited onto the substrate/material "A" surface.

In a preferred embodiment, depositing the nanoparticle/organic material onto the substrate/material "A" surface is done by self-assembly, including layer-by-layer deposition, of nanoparticles from organic solution.

In one embodiment, the aqueous solution, by which the water-soluble material "A" is lifted-off, has a pH value in the range of 1 to 14, preferably in the range of 5 to 9.

In one embodiment, the aqueous solution, by which the water-soluble material "A" is lifted-off contains chelating or complexing agents such as oxalate, EDTA (Ethylenediamine-N,N,N',N'-tetraacetic acid), carboxylic acids and other di- or polycarboxylic acids.

In one embodiment, the patterning of the photoresist material is done by a technique selected from the group comprising photolithography, electron beam lithography, printing, and other state-of-the-art lithography techniques.

The objects of the present invention are also solved by the use of the method for patterning organic or organic/inorganic material onto a substrate according to the method of the present invention.

In one embodiment, the method is used for patterning a layer-by-layer self assembled nanoparticle/organic component composite films.

In one embodiment, the method is used for patterning an organic or nanoparticle/organic component composite film electronic device, a sensor device, such as a chemical sensor, a chemical gas sensor, or an array of such devices.

In one embodiment, the method is used for patterning an organic or nanoparticle/organic component composite film electronic device, an optical device, such as an organic light emitting device (like a diode), an organic light detecting device (like a diode), or an array of such devices.

In one embodiment, the method is used for patterning a silan layer, a thiol layer or any other linker molecule wherein, preferably, the silan layer specifically immobilises biomolecules such as DNA molecules, protein, RNA and cells.

In one embodiment, the method is used for patterning of nanoparticle assemblies into integrated electronic circuits.

In one embodiment, the method is used for patterning of different nanoparticle assemblies onto the same substrate, for making a multi-channel optical, electronic, opto-electronic device, especially a multi-channel chemical sensor device or an array of chemical sensors.

The objects of the present invention are further solved by a pattern of organic or organic/inorganic materials which is prepared by the method according to the present invention.

In one embodiment, the pattern comprises one or more nanoparticle/organic composite film(s).

The objects of the present invention are further solved by a substrate carrying one or more pattern(s) of organic materials or organic/inorganic materials which are prepared by the method according to the present invention.

In one embodiment, the more than one patterns are different patterns.

The objects of the present invention are also solved by the use of the patterned nanoparticle film which is prepared by the method according to the present invention as a device selected from the group comprising an electronic, an optical, an opto-electronic, and a chemical sensor device.

In one embodiment, the chemical sensor device is a multi-channel chemical sensor device or an array of chemical sensors.

There are also further embodiments considered by the present invention:

In one embodiment, the semiconductor or insulator nanoparticles are doped with a Lanthanide or a transition metal.

In one embodiment, the core-shell particles are selected from the group comprising semiconducting particles with a CdSe core (small band gap) and a ZnS or CdS shell (large band gap).

In one embodiment, the metallic nanoparticles form core-shell structures with another metal, a semiconductor or an insulator (e.g. Au/SiO2, where Au forms the core embedded into a shell of SiO₂).

In one embodiment, the nanoparticles have a shape of a nanosheet (i.e. one dimension limited to below 100 nm, preferably below 30 nm, most preferably below 20 nm).

In one embodiment, the nanoparticles have a shape of a nanofiber or a nanotube (i.e. two dimenisons limited to below 100 nm, preferably below 30 nm, most preferable below 20 nm).

In one embodiment, the nanoparticles have a shape of a nanorod (i.e. two dimensions limited to below 100 nm, preferably below 30 nm, most preferable between 0.6 to 20 nm, and a third dimension limited to below 500 nm, preferably below 100 nm, most preferably below 50 nm).

In one embodiment, the nanoparticles preferably have an approximately spherical shape (i.e. all three dimensions limited to below 100 nm, preferably below 30 nm, most preferable below 20 nm).

In one embodiment, the nanoparticle/organic material contains any combination of said nanoparticles.

In one embodiment, in the nanoparticle/organic component composite film at least some nanoparticles of the composite film material are linked to the substrate surface through linker molecules, which are attached to the substrate surface and to the nanoparticle surface or to ligands, which are attached to the nanoparticle surface.

In one embodiment, the organic linker molecules have functional groups, which attach to the nanoparticle surface.

In one embodiment, the ligands are selected from the group comprising organic thiols, phosphines, phosphinoxides, amines and isocyanides.

In one embodiment, the linkage by which the nanoparticles are bound to the substrate surface is selected from the group comprising covalent bonds, hydrogen bonds, ionic interactions, complexation of metal ions, and hydrophobic interactions.

In one embodiment, the linkage between nanoparticles and the substrate surface is through a linkage selected from the group comprising silane, an amino silane, a mercaptosilane, a carboxylic acid, an ω-functionalised carboxylic acid, an organic thiol, an ω-functionalised organic thiol, an organic disulfide, an ω-functionalised organic disulfide, an organic amine, an ω-functionalised organic amine, an organic isocyanide, an ω-functionalised organic isocyanide.

In one embodiment, the organic component of the nanoparticle/organic composite film is formed by ligands, which are attached to the nanoparticle surfaces by suitable functional groups which can be the same as in solution phase, but can also be different.

In one embodiment, the organic or organic/inorganic material "B" is dissolved in an organic solution prior to being deposited onto the substrate/material "A" surface, wherein the preferred solvents used are aliphatic or aromatic hydrocarbons (e.g. hexanes or toluene), halogenated hydrocarbons (e.g. dichloromethylene), hydroxylic solvents (e.g. ethanol, methanol, etc.), amines (e.g. butylamine), pyridine, ketones (e.g. acetone), aldehydes (e.g. formaldehyde), esters (e.g. acetic acid ethylester), ethers (e.g. diethyl ester), dimethylformamide (DMF), dimethylsulfoxide (DMSO), or any combination thereof.

In one embodiment, the deposition rate is in the range between less than 1 Å/s to more than 100 nm/s.

In one embodiment, the organic solvent, by which the photoresist material is lifted-off, is selected from the group comprising acetone and any other suitable solvent which dissolves photoresist.

In one embodiment, a cleaning step is performed prior to depositing material "B" which cleaning step is done by a technique selected from the group comprising short oxygen plasma treatment.

In one embodiment, the method is combined with etching methods such as dry-etching and Ar-etching.

In one embodiment, the different patterns are arranged alternately.

In a preferred embodiment, the patterned nanoparticle films are used as a chemical gas sensor device.

As used herein, the term "organic component" refers to components consisting of a molecular structure which contains at least one covalent carbon-hydrogen (C-H) bond, or at least one covalent carbon-halogen (C-X; wherein X=F, Cl, Br, or Y) bond. Besides carbon and hydrogen or halogen, the structure may possibly also contain hetero atoms, such as N, O, S, or P. The structure or parts of the structure may consist of an aromatic or aliphatic hydrocarbon structure which contains carbon-carbon single bonds (C-C), double bonds (C=C) or triple bonds (C□C). The structure may also contain a delocalised conjugated π-electron system. In addition to carbon and hydrogen, or halogen atoms and possible hetero atoms, the molecular structure may also contain one or more metal atoms, thus forming a metal-organic compound.

As used herein, the term "inorganic component" refers to components consisting of a material which is different from the organic component as defined above. Typical examples are: carbon black (particles), metals and metal alloys (e.g. Au, Ag, Pt, Pd, Co, PtCo, etc.), metal or semiconductor chalcogenides, such as oxides, sulfides, selenides, tellurides (e.g. CdS, CdSe, CdTe, ZnO, SnO, TiO₂, etc.), metal or semiconductor nitrides, metal or semiconductor arsenides, metal or semiconductor phosphides, metal phosphates, metal sulfates, metal halogenids.

It should be noted that the "organic" and "inorganic components" may be linked with each other through covalent or any non-covalent bond.

The term "patterning" as used herein means that a pattern of material is produced onto a substrate or substrate/material surface. The pattern may be well-defined or the material may be randomly distributed.

The term "lifting-off", as used herein, means that a mask material deposited on a substrate or substrate/material surface is dissolved by an appropriate solvent and is washed or rinsed or flushed away. By this step, any other material which was previously deposited onto the mask material will be also lifted-off.

As used herein, the general term "nanoparticles" is meant to denote particles which have a size in the range of 0.5-500 nm, preferably below 100 nm, and more preferably below 50 nm. In particular, it is meant to denote nanosheets, nanofibres, nanotubes, nanorods, and spherically shaped nanoparticles.

"Semiconducting naoparticles" can be synthesised, for example, according to Murray *et al*. (1993, J Am Chem Soc 115: 8706). This and other synthesis routes are well know to persons skilled in the art.

The disclosure of embodiments where "the organic component is comprised of organic linker molecules and/or organic ligand molecules" should be understood such that the organic component may be comprised either of organic linker molecules or of organic ligand molecules or of a combination of organic linker and ligand molecules. In the latter case, the linkers can be attached to nanoparticles directly, wherein the ligands are also attached to the nanoparticles directly, or, alternatively, the linkers can be chemically linked to ligands attaching the nanoparticles, i.e. the linkers are indirectly linked to the nanoparticles by means of ligands.

"Layer-by-layer deposition" of nanoparticles and organic linker molecules is done according to Bethel *et al*. (1996, J Elektroanal Chem 406: 137).

In order to solve the described problem, the present inventors have envisaged the following method: the first step is to prepare a thin film mask from a water-soluble material "A" which covers defined areas on a solid or soft substrate onto which an organic material "B" is deposited in liquid or solid form by , e.g., spin-coating, thermal evaporation, or evaporation from the gas phase, or by any kind of deposition of a material from an organic solution. This especially includes the deposition of a film or coating by self-assembly from an organic solution, including SAMs, and metal or semiconducting nanoparticles from organic solvents. Optionally, the deposition of the water-soluble material "A" is combined with a patterning of photoresist material. In one embodiment, the water-soluble material "A" is deposited onto a photoresist material layer, in another embodiment, the photoresist material is patterned onto a layer of water-soluble material "A". A subsequent dip into water with pH values around 7 provides a lift-off of the mask material "A" (and optionally photoresist material) and therefore also of material "B" at those areas where the substrate was covered by material "A". The orthogonal solubility of "A" and "B" provides the possibility of surface patterning by lift-off techniques. The water should not affect the properties of material "B" which remains on the previously not-masked areas. Due to the use of the water-soluble sacrificial mask, the method is especially suited for the highly selective layer-by-layer self-assembly of nanostructured films, such as films from nanoparticles.

### Detailed description of the invention

The present invention should now be further illustrated with reference to particular examples and to the figures, in which:
- Table 1: shows the etching rates of a material comprising Ca, CaO and/or Ca(OH)₂ and any combination thereof (in the following referred to as "Ca/CaO/Ca(OH)₂").
- Figure 1: shows the process steps for patterning of an organic or organic/inorganic material according to Route A.
- Figure 2: shows the process steps for patterning of an organic or organic/inorganic material according to Route B.
- Figure 3: shows an optical microscope picture of the electron beam resist structure after development (Route A).
- Figure 4: shows an optical microscope picture of the electron beam resist structure plus the evaporated Ca/CaO/Ca(OH)₂ layer (Route A).
- Figure 5: shows an optical microscope picture of the Ca/CaO/Ca(OH)₂ structure on the wafer surface after the resist lift-off (Route A).
- Figure 6: shows an optical microscope picture of the Ca/CaO/Ca(OH)₂ structure after the silanisation and the deposition of seven layers of nanoparticles (Route A).
- Figure 7: shows an optical microscope picture of the nanoparticle layer structure after the Ca/CaO/Ca(OH)₂ lift-off (Route A).
- Figure 8: shows an optical microscope picture of the Ca/CaO/Ca(OH)₂ layer after etching (Route B).
- Figure 9: shows an optical microscope picture of the Ca/CaO/Ca(OH)₂ structure after the silanisation and seven deposition cycles of nanoparticles (Route B).
- Figure 10: shows an optical microscope picture of the samples shown in *Figure 9* after the Ca/CaO/Ca(OH)₂ lift-off (Route B).
- Figure 11: shows an optical microscope picture of a sample with 14 deposition cycles after the Ca/CaO/Ca(OH)₂ lift-off (Route B).
- Figure 12: shows an SEM picture of a sample shown in *Figure 9* patterned by using a Ca/CaO/Ca(OH)₂ mask after removing the mask material.
- Figure 13: shows an optical microscope picture of the Ca/CaO/Ca(OH)₂-patterned gold nanoparticle film (*white*) on interdigitated gold electrodes. This structure represents a chemiresistor type gas sensor.
- Figure 14: shows a sensor response (ΔR/Rᵢₙ/%) of gold nanoparticle/nonanedithiol sensors. The gas was switched between dry air and 400 ppm toluene in dry air (3 times). In all cases, the resistance increased upon exposure to toluene. The responses of a sensor prepared according to Route A (*open circles*) and Route B (*full squares*) are plotted.
- Figure 15: shows process schemes for patterning of areas with different organic materials.
- Figure 16: shows a fluorescence image of areas on a silicon wafer which were patterned according to the described process, wherein labelled DNA is present.
- Figure 17: shows a fluorescence image of areas on a silicon wafer which were patterned according to the described process, wherein labelled DNA is present.
- Figure 18: shows the process steps for patterning of an organic materials into a trench structure.
- Figure 19: shows the process steps for patterning of electrodes onto organic or inorganic materials or combinations hereof.

### Examples

### Example 1: Patterning organic or organic/inorganic materials - Route A

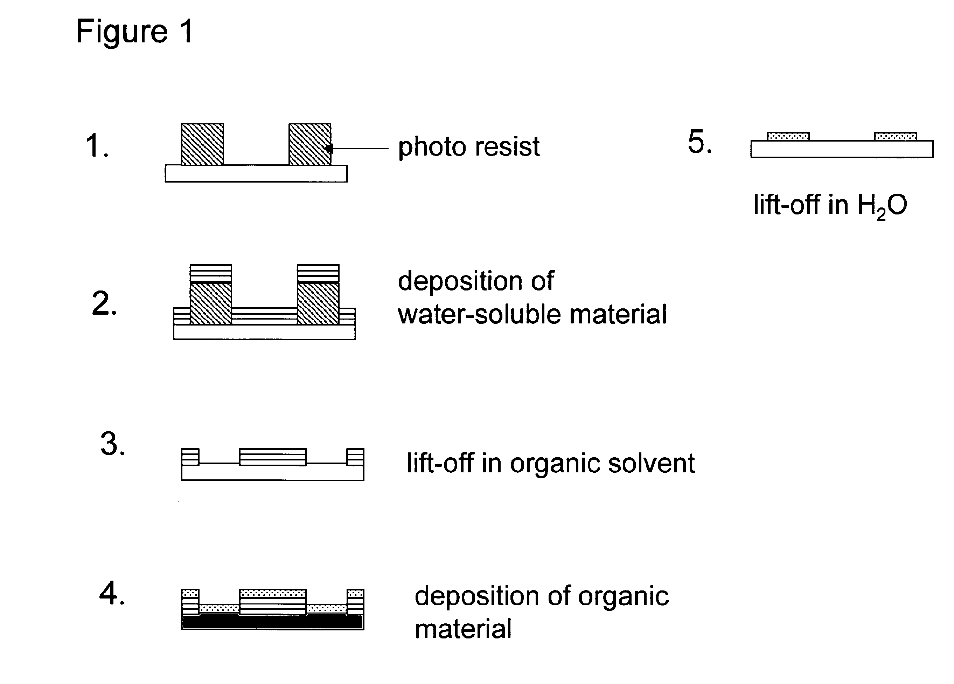

Step 1: A photoresist mask is patterned by either photolithography, electron beam lithography, or printing onto a solid or soft substrate (see Step 1 of *Figure 1*.)

The thickness of the mask material "A" can be varied in large range between less than 1 nm and more than 2 µm. Preferably, the mask thickness should be larger than the thickness of the deposited material "B" (see below) in order to provide a successful lift-off.

In addition, it can be advantageous to cover the water-soluble mask by a thin layer of insoluble material like aluminium, ZrO₂, or other materials that can form thin layers. This would stabilise the water-soluble mask during the process steps (against humidity, for example).

Step 2: 1 to 20,000 nm (preferably 20 to 1,000 nm) of water-soluble materials (material "A") is deposited by thermal evaporation (including e-gun) or sputtering, or is spin-coated onto this photomask (see Step 2 *of Figure 1*). The deposition rate can be in the range of less than 1 Å/s up to more than 100 nm/s. In case that metallic material is deposited which has to be changed into a water-soluble oxide, the chamber can be partly (sputtering) or completely filled (preferably after deposition) with oxygen, oxygen plasma, or ambient atmosphere. Material "A" can be any kind of water-soluble material from the group of metal oxides, ceramics, polymers, organic monomers or inorganic materials that can form thin layers.

Step 3: A lift-off in an organic solvent like acetone is performed (Step 3 of *Figure 1*). After this process step, patterns of the water-soluble material "A" are remaining on the substrate surface.

Step 4: A short oxygen plasma treatment or an equivalent cleaning step is applied in order to clean the substrate surface from any remaining resist and other organic contamination.

Step 5: The organic or organic/inorganic material "B" which is soluble in organic solvents is deposited onto the substrate surface wherein the preferred solvents used are aliphatic or aromatic hydrocarbons (e.g. hexanes or toluene), halogenated hydrocarbons (e.g. dichloromethylene), hydroxylic solvents (e.g. ethanol, methanol, etc.), amines (e.g. butylamine), pyridine, ketones (e.g. acetone), aldehydes (e.g. formaldehyde), esters (e.g. acetic acid ethylester), ethers (e.g. diethyl ether), dimethylformamide (DMF), dimethylsulfoxide (DMSO), or any combination thereof. This can be done by spin-coating, gas-phase deposition, thermal evaporation, dipping into a solution, or by any other kind of deposition of a material from an organic solution. The organic material comes into direct contact with the substrate surface at those areas that were not covered by the mask material "A" (see Step 4 of *Figure 1*).

Step 6: The water-soluble material "A" is dissolved by dipping-in the sample into an etch solution which mainly consists of water having a pH value in the range of 1 to 14, preferably in the range of 5 to 9. The material "B" is lifted at those positions where material "A" is present. Depending on the mechanical properties of material "B" and its binding strength to the substrate surface, ultrasonic sound can be applied to speed up the lifting process. Finally, the material "B" remains at those areas that were previously not covered by material "A" (see Step 5 of *Figure 1*).

Alternatively, Step 6 can be skipped for certain applications, for example if just the contact area between the thin film (material "B") and the substrate has to be confined. In this case, the mask material "A" with material "B" on top can remain on the substrate surface.

### Example 2: Patterning organic or organic/inorganic materials - Route B

The above described process steps of Route "A" can also be arranged in a slightly different order. In this case, the water-soluble material "A" is deposited on a solid or soft substrate first and then, structures are introduced through a lithographic step on top of the water-soluble mask and subsequent water-etching.

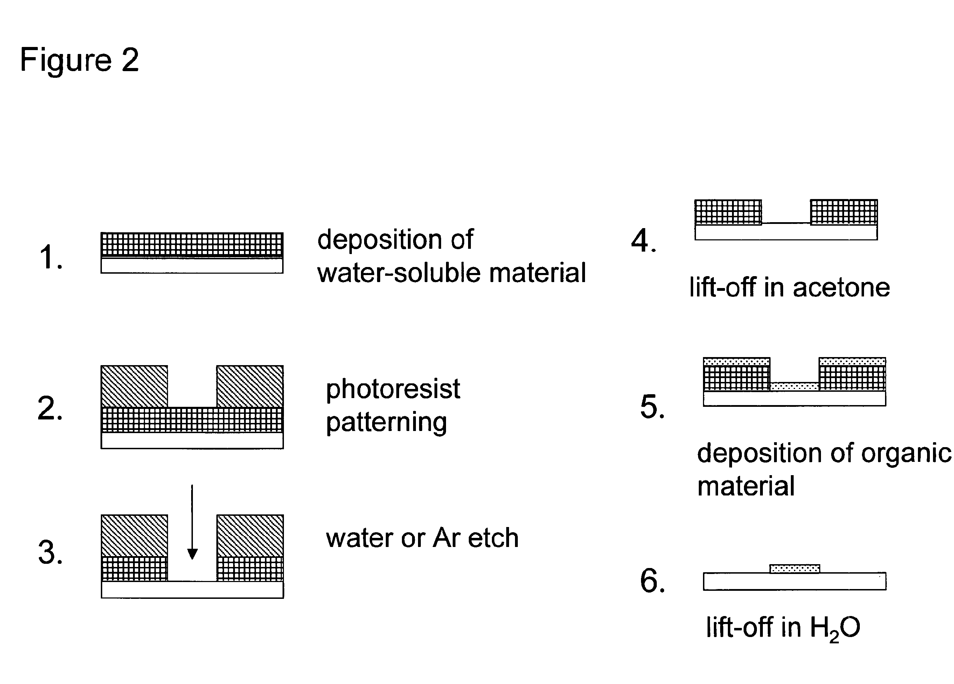

Step 1: Typically 100 to 200 nm of water-soluble material (material "A") is deposited by thermal evaporation (including e-gun), or sputtering, or is spin-coated onto a solid or soft substrate (see Step 1 of *Figure* 2). The deposition rate can be in the range of less than 1 Å/s up to more than 100 nm/s. In the case that metallic material is deposited which has to be changed into a water-soluble oxide, the chamber can be partly (sputtering) or completely filled (preferably after deposition) with oxygen, oxygen plasma or ambient atmosphere. Material "A" can be any kind of water-soluble material from the group of metal oxides, ceramics, polymers, organic monomers, and inorganic materials that can form thin layers.

The thickness of the mask material "A" can be varied in large range between less than 1 nm and more than 2 µm. Preferably, the mask thickness should be larger than the thickness of the deposited material "B" (see below) in order to provide a successful lift-off.

In addition, it can be advantageous to cover the water-soluble mask by a thin layer of insoluble material like aluminium, ZrO₂, or other materials that can from thin layers. This would stabilise the water-soluble mask during the process steps.

Step 2: A photoresist mask is patterned either by photolithography, electron beam lithography or printing onto the material "A" (see Step 2 of *Figure 2*).

Step 3: The water-soluble material "A" is dissolved by dipping the sample into an etch solution which mainly consists of water having a pH value in the range of 1 to 14, preferably in the range of 5 to 9. Slight ultrasonic sound can be applied to speed up the dissolving. Finally, the material "A" remains at those areas where it is covered by the resist mask (see Step 3 of *Figure* 2). An alternative patterning method would be to etch the mask material by using dry etching, for example argon etching. In this case, a hard metallic mask could be used in addition to the photoresist on top of the mask material "A".

Step 4: The resist is dissolved in an organic solvent like acetone. After this process step, patterns of the water-soluble material "A" are remaining on the substrate surface (see Step 4 of *Figure 2*).

Step 5: A short oxygen plasma treatment or an equivalent cleaning step is applied in order to clean the substrate surface from any remaining resist and other organic contamination.

Step 6: The organic material "B" is deposited onto the substrate surface. This can be done by spin-coating, gas-phase deposition, thermal evaporation, dipping into a solution or by any kind of deposition of a material from an organic solution. The organic material comes into direct contact with the substrate surface at those areas that were not covered by the mask material "A" (see Step 5 *of Figure 2*).

Step 7: The water-soluble material "A" is dissolved (lifted) by dipping the sample into an etch solution which mainly consists of water having a pH value in the range of 1 to 14, preferably in the range of 5 to 9. Depending on the mechanical properties of material "B" and its binding strength to the substrate surface, ultrasonic sound can be applied to support the lifting process. Finally, the material "B" remains at those areas that were previously not covered by material "A" (see Step 6 of *Figure 2*).

Alternatively, Step 7 can be skipped for certain applications, for example if just the contact area between the thin film (material "B") and the substrate has to be confined. In this case, the mask material "A" with material "B" on top can remain on the substrate surface.

### Example 3a: Patterning of an inorganic/organic composite film comprised of gold nanoparticles and organic linker molecules (Route A)

In this example, it is demonstrated that a layer of Ca/CaO/Ca(OH)₂ can be employed as water-soluble mask material "A" to pattern a composite film from gold nanoparticles and organic linker molecules.

Step 1: Standard Ti35E or Az5214 photoresist was spin-coated onto a silicon wafer or glass wafer at 4,000 rpm to a final thickness of about 3 µm. After baking at 90°C for 2 minutes, the resist was exposed for 10 seconds at 365 nm using a contact aligner. Then, the resist was developed in MIF826 developer for 1 to 2 minutes and rinsed with water.

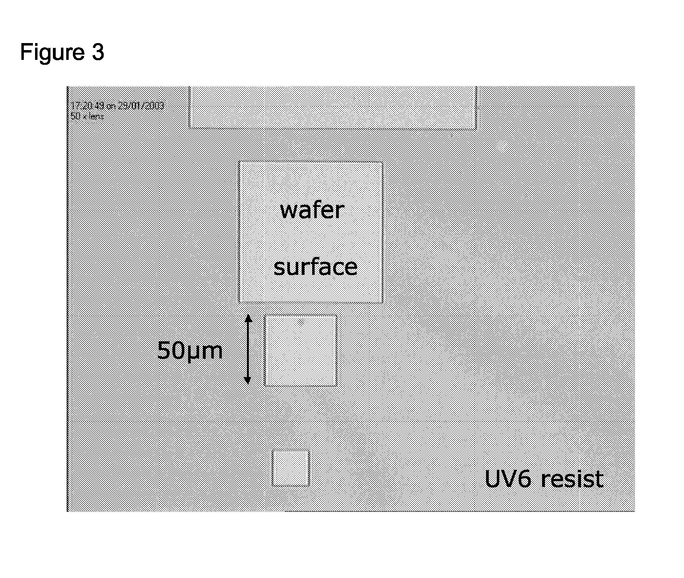

Alternatively, UV6.06 electron beam resist was spin-coated at 4,000 rpm and baked at 130°C for 60 seconds. Then the resist was exposed at 10 kV using a dose of about 15µC/cm². *Figure 3* shows an optical microscope picture of the electron beam resist structure after development.

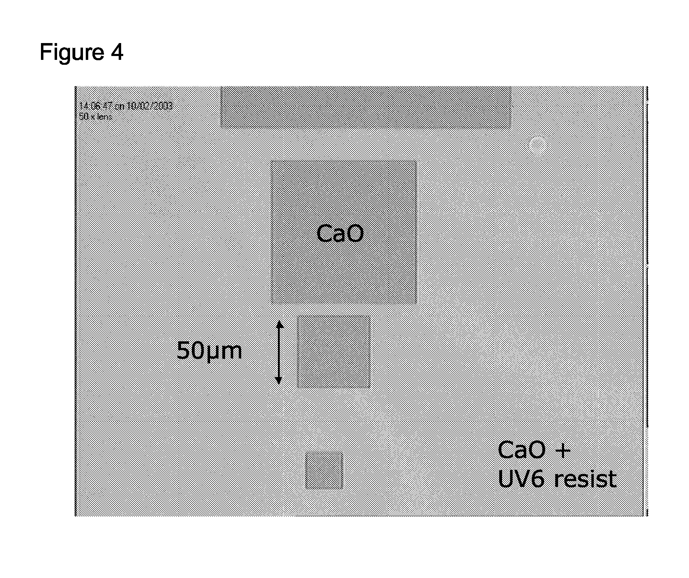

Step 2: 25 to 200 nm of metallic calcium (Ca) were evaporated by thermal evaporation onto the prepared substrate. The deposition rate was in the range 0.5-5 Å/sec. After the Ca deposition, the chamber is flooded with ambient air, which leads to an oxidation of the thin Ca film. A 5-10 nm thin aluminium layer can be deposited onto the Ca/CaO/Ca(OH)₂ afterwards in order to protect the Ca/CaO/Ca(OH)₂ layer. *Figure 4* shows an optical microscope picture of the electron beam resist structure plus the evaporated Ca/CaO/Ca(OH)₂ layer.

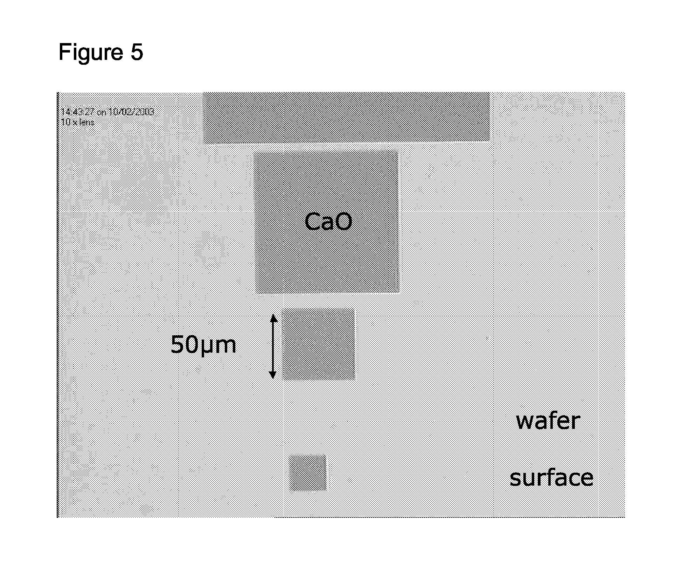

Step 3: A lift-off of the resist layer is performed in acetone. After this process step, patterns of the Ca/CaO/Ca(OH)₂ layer are remaining on the water surface. *Figure 5* shows an optical microscope picture of the Ca/CaO/Ca(OH)₂ structure on the substrate surface after the resist lift-off.

Step 4: A short oxygen plasma treatment is applied in order to clean the substrate surface from any remaining resist and other organic contamination.

Step 5: The surface of the substrate is silanised by immersing the substrate for 30 minutes in a solution of aminosilane in toluene at 60°C. The silane binds to the SiO₂ areas, which are not covered by Ca/CaO/Ca(OH)₂.

The nanoparticles used here were amine-stabilised gold nanoparticles prepared as follows. To a rapidly stirred solution of 160 mg (0.53 mmol) AuCl₃ in 20 mL de-ionized water, a solution of 639 mg (1.17 mmol) tetraoctylammoniumbromide in 20 mL toluene were added. It was stirred until the organic phase turned into orange-red, while the aqueous phase turned colourless. To the mixture, 1178 mg (6.37 mmol) dodecylamine and 30 mL toluene were added. Under vigorous stirring a freshly prepared solution of 228 mg (6.03 mmol) NaBH₄ in 15 mL water was added. The colour of the solution immediately changed to deep purple. After stirring overnight, the organic phase was separated and 40 mL ethanol were added. Then, the mixture was stored in a freezer at -18°C overnight. By filtration through a nylon membrane (0.45 µm pore size) the precipitate was separated from the solution. The solution was further subjected to fractionated precipitation which was done by repeating the following three steps: 1. Addition of ethanol (ca. 40 mL), 2. Cooling overnight in a freezer (-18 °C), 3. Separation of the precipitate by filtration, and re-dissolving the precipitate in a few mL of toluene. The linker used was 1,9-nonanedithiol (purchased from Aldrich).

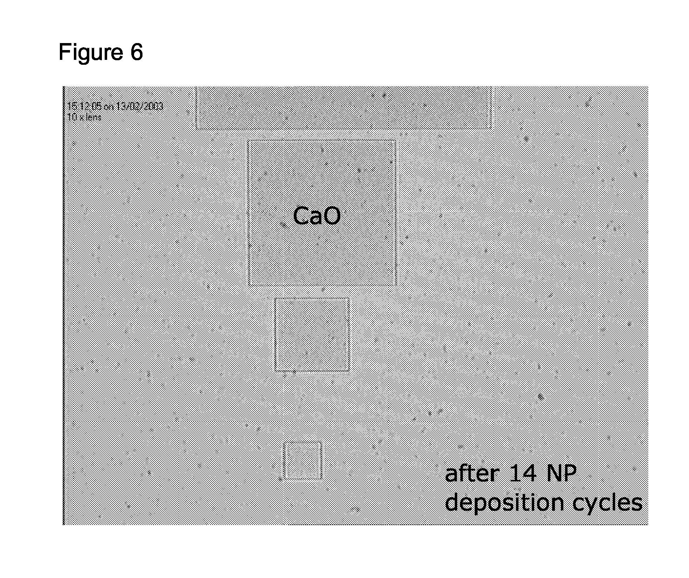

After this, the composite film of metal nanoparticle and organic linker was deposited using the self-assembly properties of the materials. Deposition was performed using the layer-by-layer technique. The substrate was first treated with the metal particle solution to form a metal nanoparticle layer. This is then washed and exposed to a solution of an organic linker. These two steps are repeated until a film of required thickness is obtained. *Figure 6* shows an optical microscope picture of the Ca/CaO/Ca(OH)₂ structure after the silanisation and after repeating the deposition of several films.

Step 6: The Ca/CaO/Ca(OH)₂ layer is dissolved by dipping the sample into an etch solution of water which was made slightly acidic by adding H₂SO₄ to reach a pH of 5 to 6. The etching rate of Ca/CaO/Ca(OH)₂ increases with decreasing pH value. *Table 1* gives the etching rates at different pH values.

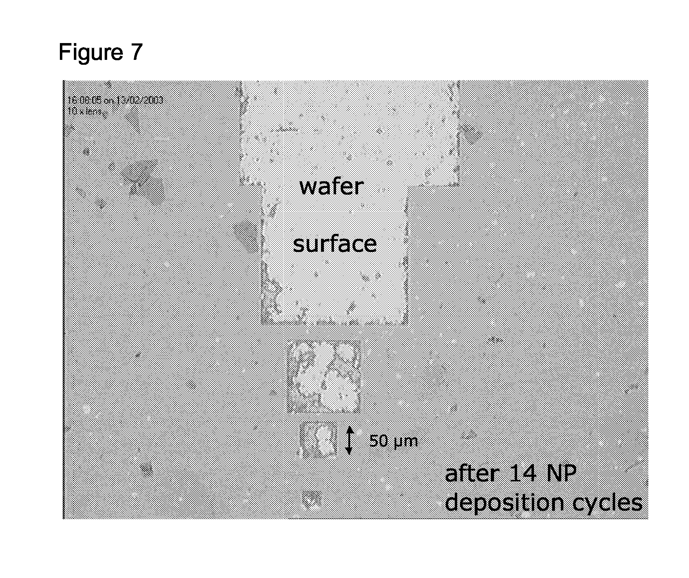

The nanoparticle layer is lifted at those positions where material Ca/CaO/Ca(OH)₂ is dissolved. Slight ultrasonic sound can be applied for a couple of seconds to support the lifting process. Finally, the gold nanoparticle layers remain at those areas that were previously not covered by Ca/CaO/Ca(OH)₂. *Figure 7* shows an optical microscope picture of the nanoparticle layer structure after the Ca/CaO/Ca(OH)₂ lift-off.

### Example 3b: Patterning of an inorganic/organic composite film comprised of gold nanoparticles and organic linker molecules (Route B)

Now "Route B" is described to pattern a film from gold nanoparticles and organic linker molecules by using a layer of Ca/CaO/Ca(OH)₂ as water-soluble mask material "A".

Step 1: 25 to 200 nm of metallic calcium (Ca) were evaporated by thermal evaporation onto siliconoxide or glass. The deposition rate was in the range 0.5-5 Å/sec. After the Ca deposition, the chamber is flooded with ambient air, which leads to an oxidation of the thin Ca film. A 5-10 nm thin aluminium layer can be deposited onto the Ca/CaO/Ca(OH)₂ afterwards in order to protect the Ca/CaO/Ca(OH)₂ layer.

Step 2: Standard Ti35E or Az5214 photoresist was spin-coated onto the prepared sample at 4,000 rpm to a final thickness of about 3 µm. After baking at 90°C for 2 minutes, the resist was exposed for 10 seconds at 365 nm using a contact aligner. Then, the resist was developed in MIF826 developer for 1 to 2 minutes.

Alternatively, UV6.06 electron beam resist was spin-coated at 4,000 rpm and baked at 130°C for 60 seconds. Then the resist was exposed at 10 kV using a dose of about 15µC/cm².

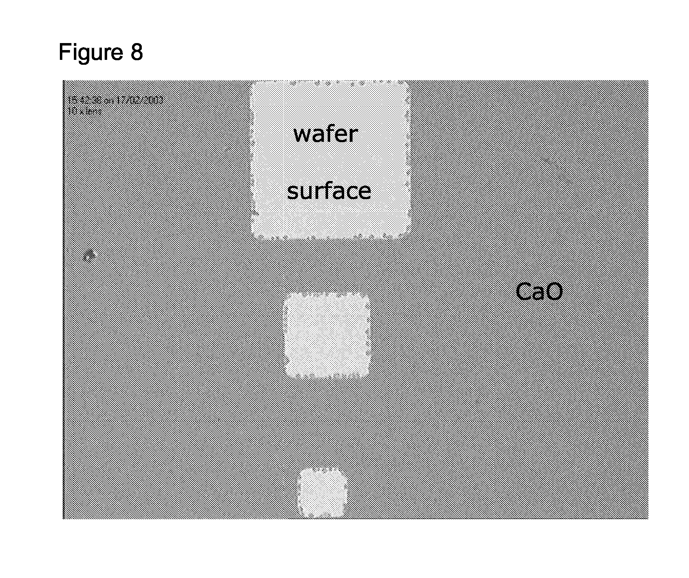

Step 3: The Ca/CaO/Ca(OH)₂ layer is dissolved by dipping the sample into an etch solution of water which was made slightly acidic by adding H₂SO₄ to reach a pH of 5 to 6. The etching rate of Ca/CaO/Ca(OH)₂ increases with decreasing pH value. *Table 1* gives the etching rates at different pH values. The Ca/CaO/Ca(OH)₂ layer could be actually already partly etched because of a water dip after the development step (Step 2). *Figure 8* shows an optical microscope picture of the Ca/CaO/Ca(OH)₂ layer after etching.

Step 4: A lift-off of the resist layer is performed in acetone. After this process step, patterns of the water-soluble material "A" are remaining on the substrate surface.

Step 5: A short oxygen plasma treatment is applied in order to clean the Ca/CaO/Ca(OH)₂ surface from any remaining resist and other organic contamination.

Step 6: The surface of the substrate is silanised by immersing the substrate for 30 minutes in a solution of aminosilane in toluene at 60°C. The silane binds preferably to the SiO₂ areas, which are not covered by Ca/CaO/Ca(OH)₂.

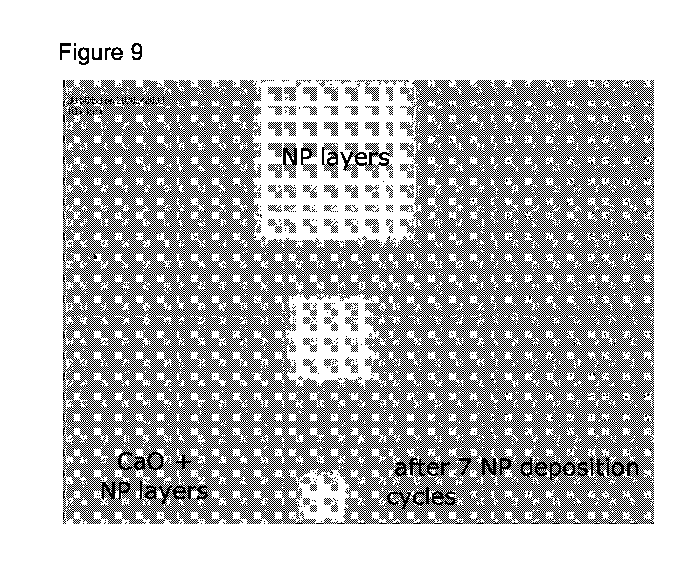

After this, the composite film of metal nanoparticles and organic linkers was deposited using the self-assembly properties of the materials. Deposition was performed using the layer-by-layer technique. The substrate was first treated with the metal particle solution to form a metal nanoparticle layer. This is then washed and exposed to a solution of an organic linker. These two steps are repeated until a film of required thickness is obtained. *Figure 9* shows an optical microscope picture of the Ca/CaO/Ca(OH)₂ structure after the silanisation and the deposition of seven layers of nanoparticles.

Step 7: The Ca/CaO/Ca(OH)₂ layer is dissolved by dipping the sample into an etch solution of water which was made slightly acidic by adding H₂SO₄ to reach a pH of 5 to 6. The etching rate of Ca/CaO/Ca(OH)₂ increases with decreasing pH value. *Table 1* gives the etching rates at different pH values.

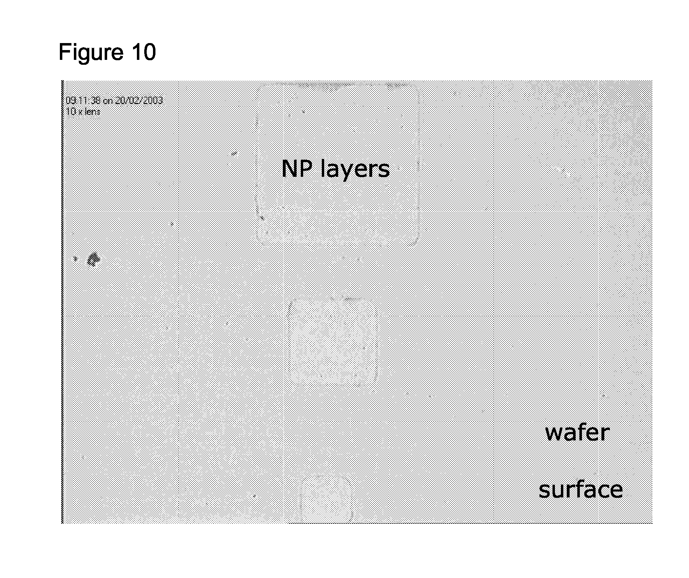

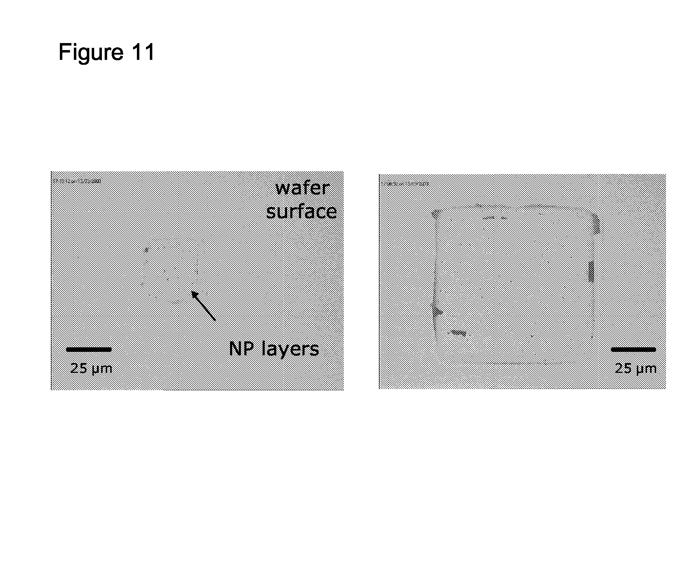

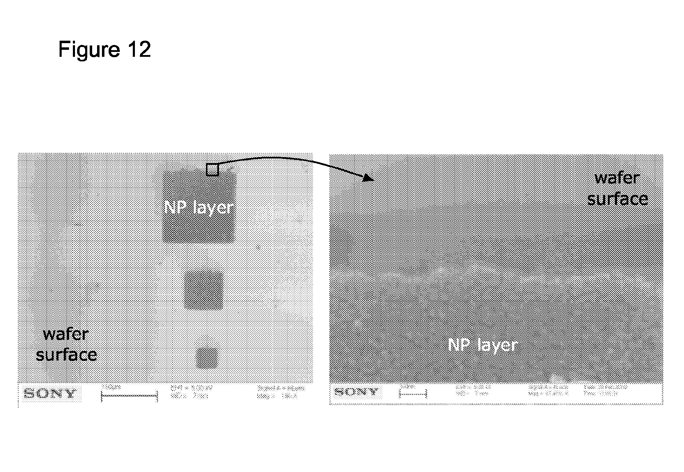

The nanoparticle layer is lifted at those positions where Ca/CaO/Ca(OH)₂ is dissolving. Slight ultrasonic sound can be applied for a couple of seconds to support the lifting process. Finally, the gold nanoparticle layers remain at those areas that were previously not covered by Ca/CaO/Ca(OH)₂. *Figure 10* shows an optical microscope picture of the nanoparticle layer structure after the Ca/CaO/Ca(OH)₂ lift-off. *Figure 11* shows a similar sample (14 deposition cycles of nanoparticles; slight ultrasonic sound was applied for 20 seconds in order to support the Ca/CaO/Ca(OH)₂ lift-off). *Figure 12* shows scanning electron microscopy pictures of the sample made by seven deposition cyles. No non-selective binding can be observed.

### Example 4: Patterning of inorganic/organic composite film sensor devices

The films mentioned in *Example 3a* and *3b* can be used for chemical sensor applications (Joseph *et al*. 2003, J Phys Chem B 107: 7406). The sorption of analytes changes the resistance of the inorganic/organic films (Kastreva *et al*. 2002, Nano Lett. 2: 551). The method can be used both for patterning the sensing areas and integrating different types of sensors (different types of molecule-nanoparticle composites) to the same substrate (see *Example 5*).

Chemical sensors based on inorganic/organic composite films, specifically layers of 4 nm gold nanoparticles stabilised with dodecylamine and linked with nonanedithiol, were deposited onto substrates with interdigitated gold electrodes (the doceylamine stabiliser is not present any longer after film formation).

The substrate was from BK7 glass or oxidised silicon wafers. For investigating the electronic and vapour sensing properties, the glass substrates were equipped with interdigitated gold electrode structures (50 finger pairs, 10 µm width and 100 nm height, including a 5 nm titanium adhesion layer, 10 µm spacing, 1,800 µm overlap).

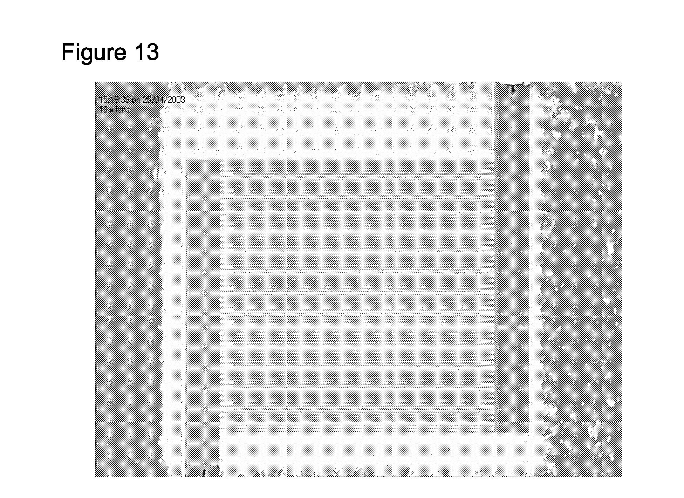

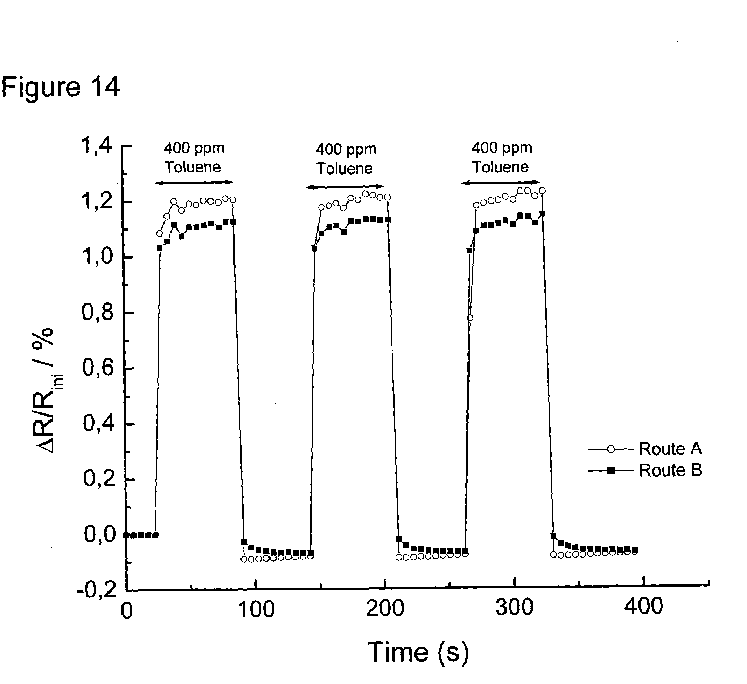

The films were patterned according to Route A or Route B using Ca/CaO/Ca(OH)₂ as mask material. *Figure 13* shows a picture of the resulting sensor film. *Figure 14* displays the sensor response of the patterned films to 400 ppm toluene for case of Route A and B, respectively. The patterned sensors are sensitive to the analyte in a similar way as the non-patterned films are. These data confirm that the Ca/CaO/Ca(OH)₂ patterning process does not destroy the sensor properties.

### Example 5: Patterning of different types of inorganic/organic composite films comprised of gold nanoparticles and organic linker molecules on the same substrate

This example describes the fabrication of different types of inorganic/organic composite films comprised of gold nanoparticles and organic linker molecules on the same substrate. This is particularly interesting for the integration of different types of thin film sensors on the same substrate, e.g. a multi-channel sensor array.

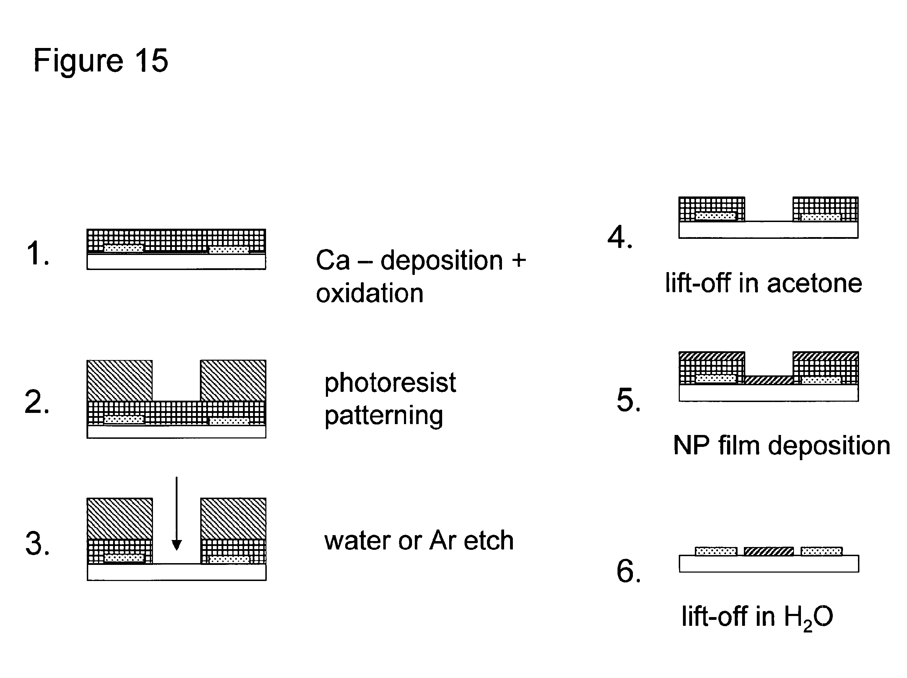

First, the inorganic/organic composite film "X" is patterned on a solid or soft substrate surface by applying Route "A" or Route "B". Then, Route "B" is applied for the inorganic/organic composite film "Y". The schemes for Route "B" are shown in *Figure 15* for this particular application. The water-soluble mask material is preferably Ca/CaO/Ca(OH)₂. The mask material, however, can be also made from other water-soluble materials like metal oxides, ceramcis, polymers, organic monomers and inorganic material that can form thin layers.

An additional possible patterning route is to first pattern "X" as described above, and then to use an organic resist system to pattern a water-soluble material "Z" by lifting-off the resist in an organic solvent which does not harm the water-soluble material "Z" and also not the inorganic/organic material "X" (e.g. interlinked nanoparticles).

### Example 6: Patterning of a silane layer for specific immobilisation of DNA molecules

This example demonstrates that the method of the present application can be used to pattern silan layers that function as binding sites for molecules, biomolecules, nanowires and nanoparticles. This example specifically demonstrates the binding of DNA molecules to a patterned mercaptosilane layer. The water-soluble material is again Ca/CaO/Ca(OH)₂ in this example.

Either Route "A" or Route "B" can be applied. Route "A" is applied up to Step 4. The following steps are as follows:

Step 5: The surface of the substrate is silanised by immersing the substrate for 90 minutes into a mercaptosilane solution. The silane binds preferably to those SiO₂ areas, which are not covered by Ca/CaO/Ca(OH)₂. Baking at 120°C for 1 hour follows.

Step 6: The Ca/CaO/Ca(OH)₂ layer is dissolved by dipping the sample into an etch solution of water which was made slightly acidic by adding H₂SO₄ to reach a pH of 5 to 6. The etching rate of Ca/CaO/Ca(OH)₂ increases with decreasing pH value. *Table 1* gives the etching rates at different pH values. The silane layer remains at those areas that were previously not covered by Ca/CaO/Ca(OH)₂.

Step 7: One drop of thiolated DNA is applied to the pre-treated substrate for 30 minutes. During this period, the DNA attaches to the silanised pattern on the substrate surface. The attached DNA can be either (a) single stranded or (b) double stranded. The single stranded DNA (a) can be hybridised with its complementary part which can be labelled or non-labelled. For the latter case, a label can be applied to the hybridised DNA. The double stranded DNA (b) can be labelled prior binding to the silan or afterwards.

In this example, the immobilised DNA was single stranded. The complementary part that contained a Cy3-fluorescence marker (excitation: 550 nm, emission: 570 nm) at its end was hybridised to the immobilised DNA.

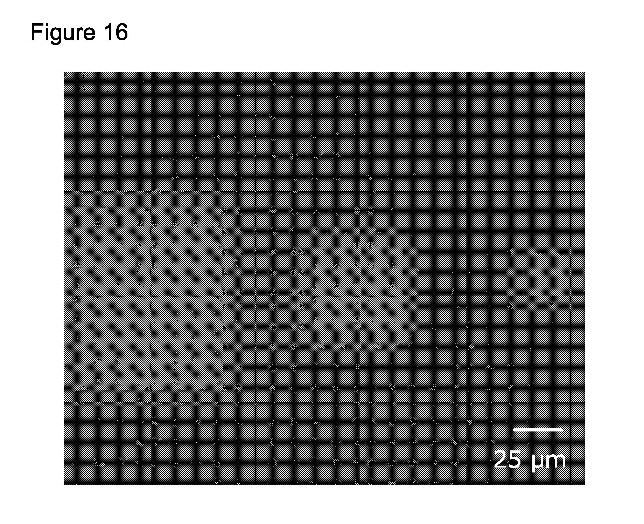

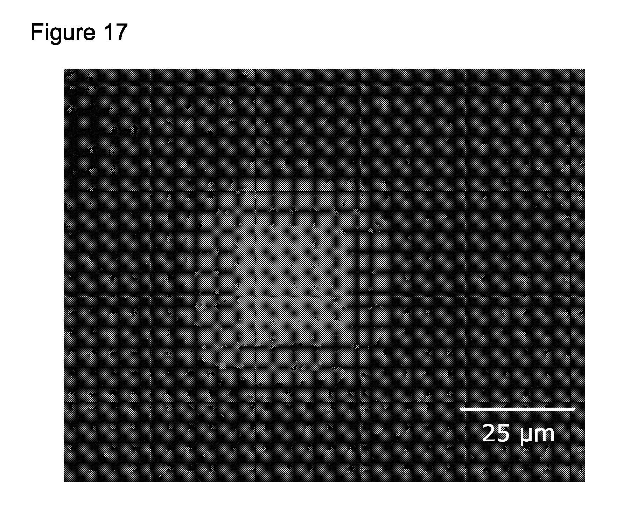

*Figure 16* and *17* show the fluorescence image of areas on a silicon wafer, which were patterned according to the described process. The bright areas represent the red fluorescence emission from the Cy3-marker of the immobilised DNA. The picture shows that the binding is highly selective.

### Example 7: Water-soluble mask process to integrate organic/inorganic materials into structures by using dry etching methods

This example describes how the method of using a water-soluble mask can be combined with dry and reactive etching methods to integrate a trench into the target device structure.

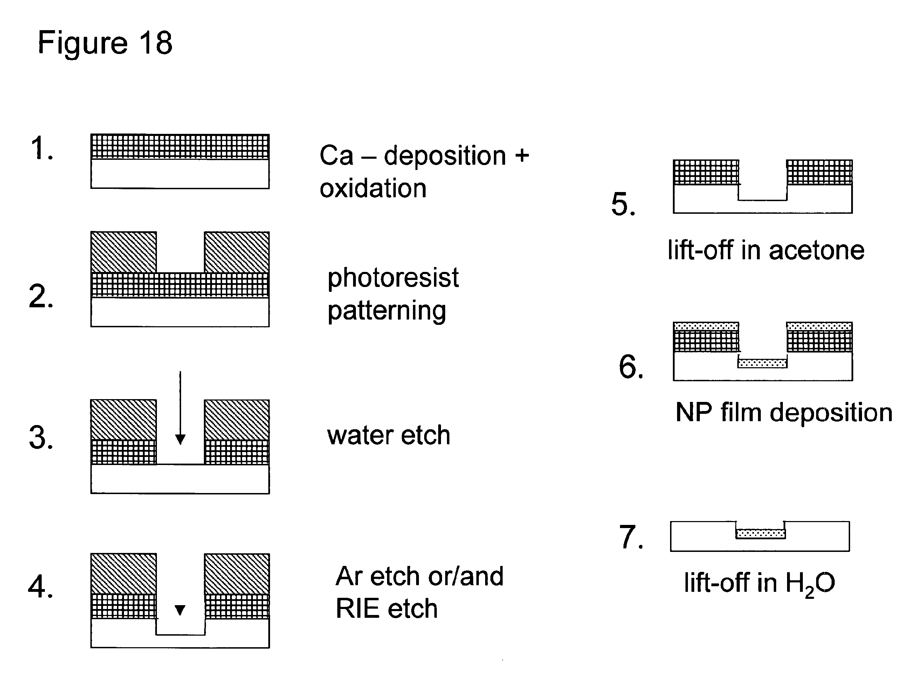

Route A or Route B is used to pattern a water-soluble mask material on any kind of substrate material that can be etched by reactive ion (RIE) or ion beam etching. Preferred substrate materials are insulators like SiO₂, glass, perovskite, and conducting materials like gold, silver, aluminium, and palladium (*Figure 18,* Steps 1-3, Route B).

The patterned water-soluble mask material serves as mask for a RIE or ion beam etching step. This step introduces a trench structure into the substrate material (*Figure 18,* Step 4). In order to make the water-soluble mask material more stable against this etching step, a thin hard mask (e.g. Ti, Cr or other mask materials which show a low ion-etching rate) could be introduced on top of the water-soluble mask.

Then, the organic material "B" is deposited onto the water-soluble mask and thus also into the trench structure (*Figure 18,* Step 6). Finally, a lift-off of the water-soluble mask is performed so that material "B" remains inside the trench structure.

### Example 8: Fabrication of electrode structures on top of organic/inorganic materials by using a water-soluble mask

This example describes how top electrodes can be made on top of nanostructures by employing the method of the present application. The advantage of using this method is that the nanoobject does not come into contact with organic solvent but just with water with a certain pH value.

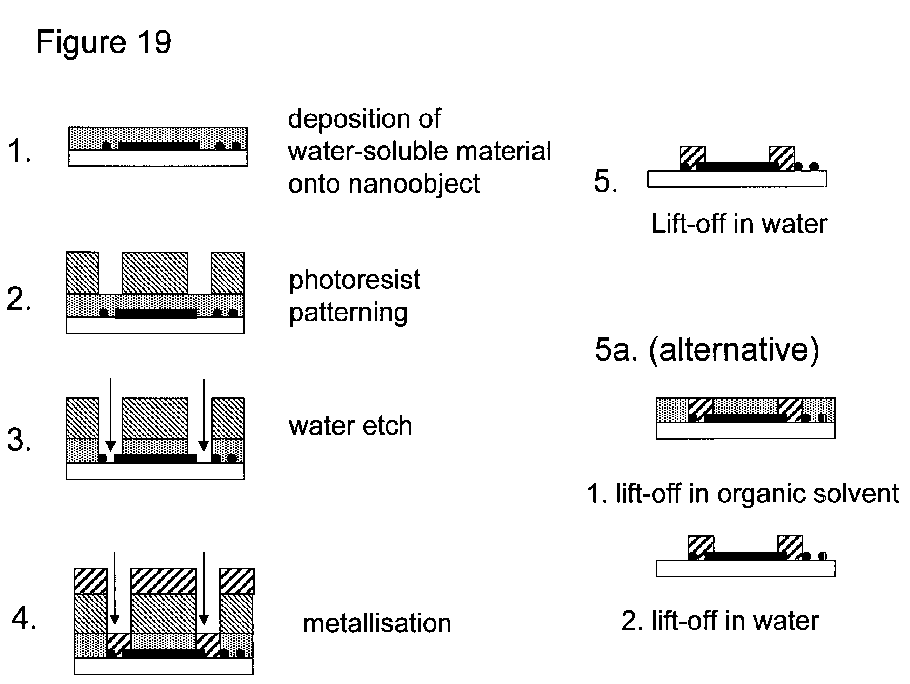

*Figure 19* shows the process steps. In Step 1, a water-soluble material, specifically Ca/CaO/Ca(OH)₂, is deposited onto a substrate which contains nanoobjects like organic or inorganic or combinations of fibres, rods, wires, sheets, arrays of particles on the surface. These nanoobjects specifically could be carbon nanotubes, semiconducting objects like ZnO rods or V₂O₅ fibres, or metallic objects like metallised DNA wires, as well as insulating objects from polymers or biological material.

In Step 2, a resist is patterned on top of the water-soluble material.

In Step 3, the water-soluble material is etched by water at those areas, which are not covered by the resist.

Then, the gaps are filled by evaporated metal (specifically, Cr, Al, Ti as adhesion layer; Au, Pt, Ag, Al, Pd, PdAu as main electrode material) to create electrodes (Step 4).

Finally, a lift-off in water can be performed to lift the resist and excess metal (Step 5a).

Alternatively, a lift-off in acetone or other solvent which dissolves the resist can be applied first (Step 5b1), followed by a lift-off step in water to remove the water-soluble mask (Step 5b2).

### Example 9: Layer-by-layer deposition procedure

The layer-by-layer deposition is carried out by the following steps:
Step 1: The substrate surface is functionalised with a suitable organic compound, preferably selected from: a silane, an amino silane, a mercaptosilane, a carboxylic acid, an ω-functionalised carboxylic acid, an organic thiol, an ω-functionalised organic thiol, an organic disulfide, an ω-functionalised organic disulfide, an organic amine, an ω-functionalised organic amine, an organic isocyanide, an ω-functionalised organic isocyanide. The functionalisation of the substrate is done either by treating the substrate with the said compound in solution or in the vapour phase.
Step 2: After cleaning the substrate with solvent, a solution or dispersion of nanoparticles (preferably in the organic solvents listed above) is applied to the substrate surface leading to the deposition of nanoparticles to the functionalised substrate surface. Binding of the nanoparticles to the substrate can be directly between the particle surfaces and the functional groups of the substrate surface, or can be between the ligands, which stabilise the nanoparticles in solution, and the surface bound functional groups.

The nanoparticles, which are applied, are stabilised in solution by organic ligand molecules which may be partly or completely exchanged, or chemically modified during the deposition process.

The ligand molecules may enhance the solubility of the nanoparticles in a suitable organic solvent which does not degrade the water soluble mask.

Step 3: After cleaning the substrate with the attached nanoparticles with solvent, a solution of linker molecules is applied, which bind to the substrate-bound nanoparticles. Binding of the linker molecules can be directly to the nanoparticle surface, or to the ligands, which may be still attached to the nanoparticles.

Step 4: The deposition of nanoparticles and linker molecules is repeated until the desired film thickness is achieved.

## Claims

1. A method of patterning organic or organic/inorganic materials onto a substrate comprising the following steps:
(1) patterning of a water-soluble material "A" onto a surface of the substrate, thereby forming a substrate/material "A" surface;
(2) depositing organic or organic/inorganic material "B" onto the substrate/material "A" surface;
(3) lifting-off material "A" in aqueous solution.

2. The method according to claim 1, wherein step (1) of patterning of the water-soluble material "A" onto the substrate comprises the following steps:
(1a) patterning of a photoresist material onto the substrate surface, thereby forming a substrate/photoresist material surface;
(1b) depositing the water soluble material "A" onto the substrate/photoresist material surface;
(1c) lifting-off the photoresist material in an organic solvent.

3. The method according to claim 1, wherein step (1) of patterning of the water-soluble material "A" onto the substrate comprises the following steps:
(1a') depositing the water-soluble material "A" onto the substrate surface, thereby forming a substrate/material "A" surface;
(1b') patterning the photoresist material onto the substrate/material "A" surface;
(1c') etching the unmasked material "A" in aqueous solution;
(1d') lifting-off the photoresist material in an organic solvent.

4. The method according to any of the preceding claims, wherein the substrate surface is solid or soft.

5. The method according to any of the preceding claims, wherein the substrate is a wafer.

6. The method according to any of the preceding claims, wherein the water-soluble material "A" is selected from the group comprising inorganic materials, such as metal oxides and ceramics, and organic materials, such as organic polymers and organic monomers.

7. The method according to any of the preceding claims, wherein the water-soluble material "A" comprises Ca, CaO and/or Ca(OH)₂, and any combination thereof.

8. The method according to any of the preceding claims, wherein a mercaptosilane layer is deposited onto the whole substrate including the water-soluble material "A" and areas which are not covered by the water-soluble material "A".

9. The method according to any of the preceding claims, wherein the organic or organic/inorganic material "B" is comprised of nanoparticles and an organic component.

10. The method according to any of the preceding claims, wherein the nanoparticles are selected from the group comprising semiconductor nanoparticles, insulator nanoparticles, metallic nanoparticles, carbon black particles, and any combination thereof.

11. The method according to claim 10, wherein the semiconductor or insulator nanoparticles are selected from the group comprising metal oxides, metal sufides, metal selenides, metal tellurides, metal phosphides, metal phosphates, II/VI semiconductors, and III/V semiconductors, and any combination thereof.

12. The method according to claims 10 or 11, wherein the semiconductor nanoparticles are core-shell particles, preferably with a larger bandgap semiconductor material encapsulating a core of a semiconductor material with a smaller band gap.

13. The method according to claim 10, wherein the metallic nanoparticles are selected from the group comprising Ag, Au, Pt, Pd, Pt/Co, and Co, and any combination thereof.

14. The method according to claim 9, wherein the organic component is comprised of organic linker molecules and/or organic ligand molecules.

15. The method according to claim 14, wherein the organic linker molecules are attached to the substrate surface and to the nanoparticle surface, thereby linking the nanoparticles to the substrate surface.

16. The method according to claims 14 or 15, wherein the organic linker molecules serve to interlink the nanoparticles.

17. The method according to any of claims 14-16, wherein the type of linkage between the nanoparticles through the organic linker molecules is selected from the group comprising covalent linkages, complexation of metal ions, hydrogen bonds, ionic interactions, and any combination thereof.

18. The method according to any of claims 14-17, wherein the organic linker molecules are linked to organic ligands, which are attached to the nanoparticles by suitable functional groups.

19. The method according to any of claims 9 and 14-18, wherein the organic component is selected from the group comprising a polymer, a dendrimer, a DNA molecule, a RNA molecule, a protein molecule, a bi- or polyfunctional organic thiol, a bi- or polyfunctional organic disulfide, a bi- or polyfunctional organic amine, a bi- or polyfunctional carboxylic acid, a bi- or polyfunctional organic phosphine, a bi- or polyfunctional organic phosphineoxide and a bi- or polyfunctional organic isocyanide, or any combination thereof.

20. The method according to any of the preceding claims, wherein the organic or organic/inorganic component "B" is a nanoparticle/organic component composite film.

21. The method according to any of claims 9, 10 and 14-20, wherein the nanoparticle/organic component composite film is a carbon-black particles/polymer composite film.

22. The method according to any of the preceding claims, wherein the deposition of the water-soluble material "A" is done by a technique selected from the group comprising thermal evaporation, electron-gun evaporation, plasma deposition, sputtering, and spin coating.

23. The method according to any of the preceding claims, wherein the deposition of the organic or organic/inorganic material "B" is done by a technique selected from the group of techniques comprising spin-coating, spray-coating, gas-phase deposition, thermal evaporation, dip-coating, drop-casting, solvent evaporation, air-brush deposition and jet-printing.

24. The method according to any of the preceding claims, wherein the organic or organic/inorganic material "B" is dissolved in an organic solution prior to being deposited onto the substrate/material "A" surface.

25. The method according to claim 24, depositing the nanoparticle/organic material onto the substrate/material "A" surface is done by self-assembly, including layer-by-layer deposition, of nanoparticles and organic linker molecules from organic solution.

26. The method according to any of the preceding claims, wherein the aqueous solution, by which the water-soluble material "A" is lifted-off, has a pH value in the range of 1 to 14, preferably in the range of 5 to 9.

27. The method according to any of the preceding claims, wherein the aqueous solution, by which the water-soluble material "A" is lifted-off contains chelating or complexing agents such as oxalate, EDTA (Ethylenediamine-N,N,N',N'-tetraacetic acid), carboxylic acids and other di- or polycarboxylic acids.

28. The method according to any of the preceding claims, wherein the patterning of the photoresist material is done by a technique selected from the group comprising photolithography, electron beam lithography, printing, and other state-of-the-art lithography techniques.

29. A use of the method for patterning organic or organic/inorganic material onto a substrate according to any of claims 1-28.

30. The use according to claim 29, wherein the method is used for patterning a layer-by-layer self assembled nanoparticle/organic component composite films.

31. The use according to claims 29 or 30, wherein the method is used for patterning an organic or nanoparticle/organic component composite film electronic device, a sensor device, such as a chemical sensor, a chemical gas sensor device, or an array of such devices.

32. The use according to claims 29 or 30, wherein the method is used for patterning an organic or nanoparticle/organic component composite film electronic device, an optical device, such as an organic light emitting device, an organic light detecting device, or an array of such devices.

33. The use according to any of claims 29-32, wherein the method is used for patterning a silan layer, a thiol layer or any other linker molecule wherein, preferably, the silan layer specifically immobilises biomolecules such as DNA molecules, protein, RNA, and cells.

34. The use according to any of claims 29-33, wherein the method is used for patterning of nanoparticle assemblies into integrated electronic circuits.

35. The use according to any of claims 29-34, wherein the method is used for patterning of different nanoparticle assemblies onto the same substrate, for making a multi-channel optical, electronic, opto-electronic device, especially a multi-channel chemical sensor device or an array of chemical sensors.

36. A pattern of organic or organic/inorganic materials which is prepared by the method according to any of claims 1-28.

37. The pattern according to claim 36 comprising one or more nanoparticle/organic composite film(s).

38. A substrate carrying one or more pattern(s) of organic materials or organic/inorganic materials which is prepared by the method according to any of claims 1-28.

39. The substrate according to claim 38 wherein the more than one patterns are different patterns.

40. A use of the patterned nanoparticle film which is prepared by the method according to any of claims 1-28 as a device selected from the group comprising an electronic, an optical, an opto-electronic, and a chemical sensor device.

41. The use according to claim 40, wherein the chemical sensor device is a multi-channel chemical sensor device or an array of chemical sensors.
